# EUROPEAN PATENT APPLICATION

(11) **EP 4 704 271 A1**
(43) Date of publication of application: **04.03.2026**
(21) Application number: 24196555.7
(22) Date of filing: 26.08.2024
(51) Int. Cl.: H02B 1/20, H05K 7/14, H02G 3/04, H02G 3/00, H02G 3/32

(54) **CABLE MANAGEMENT DEVICE**

(71) Applicant: ABB SCHWEIZ AG, 5400 Baden (CH)
(72) Inventor: WEBER, Erik, 67850 Offendorf (FR); RINGWALD, Konrad, 77880 Sasbach (DE); ROTH, Michael, 77880 Sasbach (DE)
(74) Representative: Maiwald GmbH

(57) **Abstract**

The disclosure relates to a cable management device (1) comprising a connection structure (10), the connection structure (10) comprising at least one connection element (13) for connection to a rail (110) of an electrical installation, and at least two cable holder (20) for holding one or more cables, the at least two cable holders (20) being arranged at a distance from one another on the connection structure (10), each one of the at least two cable holders (20) comprising a frame (24) to hold the one or more cables inside a space (25) enclosed by the frame (24), the frame (24) comprising at least a flexible portion (22) for receiving the one or more cables inside the space (25) and releasing them from the space (25).

## Description

### TECHNICAL FIELD

The present invention relates to a cable management device and a cable management system such as but not limited to distribution cabinets, metering cabinets, electrical automats.

### BACKGROUND

Cable holders organize and secure electrical cables and wires. Currently, cable holders are mounted individually with clips or screws. A multitude of cable holders are required to organize and secure the cables or wires in a cabinet. Currently, any user, especially an electrician, needs a lot of time to fix multiple cable holder on a rail to be used together.

Hence, there is a need to simplify the fixation of cables and to reduce the mounting time.

### SUMMARY

The above problem is at least partially solved or alleviated by the subject matters of the independent claims and aspects of the present disclosure, wherein further examples are incorporated in the dependent claims and examples of the present disclosure.

According to an aspect of the present disclosure, there is provided a cable management device comprising a connection structure. The connection structure may be comprising at least one connection element for connection to a rail of an electrical installation. The cable management device may be further comprising at least two cable holder for holding one or more cables. The at least two cable holders may be arranged at a distance from one another on the connection structure. Each one of the at least two cable holders may be comprising a frame to hold the one or more cables inside a space enclosed by the frame. The frame may be comprising at least a flexible portion for receiving the one or more cables inside the space and/or releasing them from the space.

Hence, the cable management device enables to have two or more cable holders mounted at the same time to a single rail of an electrical installation, reducing the time and effort to attach the cable holders to the rail. Moreover, the cables may be easily mounted or managed by having the frame with its space, part of which is formed by the flexible portion, through which the cables may be easily inserted and released from the space, facilitating a fast and convenient cable management.

Generally, the terms connection structure, connection element, cable holder, frame, space, flexible portions and similar terms relating to portions, elements and features of the cable management device are herein to be interpreted broadly. The connection structure may be any structure by means of which the two cable holders are provided thereon or arranged thereon and which has one or more connection elements of any type allowing them to affix the cable management device to one or more rails or other attachment structures of an electricall installation or, in other words, electrical system. The frame may fully or mostly enclose the space, in particular the frame may be fully enclosing the space when the flexible portion is not flexed or bent, thereby not opening the space to the outside for inserting therein one or more cables or releasing from there one or more cables. The flexible portion may be in particular an elastic portion. Not necessarily but potentially the flexible portion may be flexible by means of the used material. In particular, the flexible portion may be flexible, in particular relative to another part or portion of the frame, by means of its design, e.g., having a flexible or spring like shape, allowing to flex, in particular elastically, the flexible portion.

In an example, the flexible portion may comprise two flexible arms configured for receiving and releasing the one or more cables through an opening formable between the two flexible arms when flexing the flexible arms. In particular, the flexible arms may be configured, in particular attached at the frame or to another portion of the frame and relative to one another, such that by pushing cables against them, the cables may be forming the opening between the flexible arms and pushing them into the space and having them enclosed and held in place by the frame. Similarly, in particular, when pulling the cables, the flexible arms may be flexed or, in other words, bend into the opposing direction compared to the pushing action, thereby forming the opening for releaseing or removing them from the space. In particular, one of the flexible arms may be arranged on top of the other one or resting on the other one, in particular flexibly and/or with its tip or end. The flexible portion may be flexible, in particular with its flexible arms, in opposite directions, in particular for the pushing and pulling action of cables as described herein.

The frame may comprise a rigid portion for enclosing the one or more cables inside the space enclosed by the frame. The rigid portion may be arranged at the flexible portion, the rigid portion being substantially rigid or less flexible than the flexible portion. Hence, the rigidity of the rigid portion is at least such that it is less flexible than the flexible portion and optionally it may be substantially rigid. The terms flexible and rigid are thus to be seen in relative relation with respect to the rigid portion and the flexible portion. The rigid portion may ensure that the cables are securely held in place.

The connection structure, the rigid portion and/or the flexible portion may be made from the same material. For example, a plastic material may be used for light-weight and easy manfucaturing of the cable management device. In particular, the cable management device may be entirely made from the same material or monolithically designed.

The flexible portion may be flexible with respect to the rigid portion. In particular, the flexible arms may be designed flexible with respect to the rigid portion. Specifically, the flexible arms may be arranged at the rigid portion in a flexible manner such that they may be bent or flexed to form the opening therebetween, in particular in two opposite directions. The opposite directions may be towards the connection structure and away from the connection structure. In particular, the opposite directions may be substantially perpendicular to longitudinal extension of the flexible arms. Thereby, through pushing and pulling of cables into and from the space, the opening may be easily formed to receive and release the cables.

The connection structure may comprise at least two or more connection elements. In this case, the connection to the rail of the electrical installation may be provided in a particularly secure manner with little or no risk of accidentally losing connection.

The at least one connection element may comprise a snap-fit arm for establishing a snap-fit connection with the rail. In case of two or more connection elements, at least one of the connection elements may comprise a snap-fit arm for establishing a snap-fit connection with the rail. In particular, each one of the at least two connection elements may comprise a snap-fit arm. By using a snap-fit connection or joint, in particular in connection with one or more connection openings inside the rail, the cable management device may be quickly and securely attached to the rail.

The at least one connection element may comprise an at least partially rectangularly shaped projection for insertion into a rectangular connection opening inside the rail, the projection comprising the snap-fit arm. In case of two or more connection elements, at least one or both or more of the connection elements may comprise the at least partially rectangularly shaped projection for insertion into a rectangular connection opening inside the rail, the projection comprising the snap-fit arm. Alternatively, the projection may have another shape, e.g., circular. The projection may in particular be C- or U-shaped, with the snap-fit arm being arranged in between two sides or walls of the C-, U- or generally at least partially rectangulary shaped projection, where it may be flexibly held in between these. The snap-fit arm may be attached at one side and free at another side, thereby making it flexible to engage or snap-fit with the rail. The projection, in particular with its shape, allows to prevent unwanted rotation of the cable management device relative to the rail.

The cable management device may further comprise at least one further connection element or at least two further connection elements configured as through-hole(s) for establishing a screwed connection with the rail. The rail may itself comprise one or more corresponding through-holes for establishing the screwed connection. The further connection element or elements may be in addition to the other connection element or elements, in particular in the form of the snap-fit arm and projection, or alternatively thereto, in which case they may merely be referred to as connection elements.

The connection structure may comprise at least one bar element at which the two or more cable holders are arranged. The bar element may generally have an elongated or longitudinal and/or flat structure. The width of the bar element perpendicular to its length may be greater than its thickness. For example, the width of the bar element may be at least two, three or more times its thickness. Thereby, the cable management device may be securely attached to the rail without taking up much building room.

One of the at least two cable holders may be arranged substantially in parallel to at least one other of the at least two cable holders. Alternatively, one of the at least two cable holders may be arranged substantially perpendicular to at least one other of the at least two cable holders. Additionally, it may be possible to have both, parallely arranged cable holders and perpendicularly arranged cable holders. Also, it is possible to have any oblique orientation of cable holders relative to one another. Oblique herein means a degree of orientation between 0 and 90 degrees of orientation, e.g., between 5 and 85 degrees of orientation. Parallel, perpendicular and oblique herein relates to the orientation of the cable holders, in particular their frames, shape and/or planes along which they extend or in which they are located. For parallelly arranged cable holders, the cables may longitudinally or along their length extend through their spaces. With perpencidularly and obliquely arranged cable holders, the cables will have to be bent or make a curve, in particular at an oblique or substantially perpendicular angle, to extend through the spaces of the perpendicularly arranged cable holders. Thereby, it is possible to route or manage cables not only in a single direction, e.g., horizontally, but also in another direction, e.g., vertically. For example, the cables may thereby be easily routed to other parallel rails and up and down.

The connection structure may comprise two bar elements arranged oblique to one another. Advantageously, thereby, the cables may be routed or managed along the entirety of the two bar elements, while still allowing to route the cables vertically and horizontally through the differently arranged cable holders.

The two bar elements may be arranged in a substantially T-shaped form, wherein one first cable holder may be arranged at an end of a first bar element of the two bar elements, and wherein two second cable holders may be arranged substantially in parallel to each other at opposite ends of a second bar element of the two bar elements. Moreover, the second cable holders may be arranged substantially perpendicular to the first cable holder. Advantageously, thereby, the cables may be routed or managed along the entirety of the two bar elements, while still allowing to route the cables vertically and horizontally through the differently arranged cable holders.

The frame may be substantially rectangulary shaped. In particular, the frame may be substantially squarely shaped. Other shapes, such as circular, are however possible. The rigid portion may in particular be forming three sides of the frame. In particular, the rigid portion may have a C- or U-shape. On the other hand, the flexible portion may be forming the remaining side of the frame.

The cable management device may in particular comprise at least three cable holders. More particularly, the cable management device may comprise four or more cable holders. In particular the cable management device may comprise two to four cable holders. Further, in particular, the cable management device may comprise exactly three or exactly four cable holders.

According to a second aspect of this disclosure, there is provided a cable management system comprising one or more cable management devices according to the first aspect of this disclosure, vertical posts and horizontal rails, the horizontal rails being attached to the vertical posts and the one or more cable management devices being connected to one or more of the horizontal rails.

The cable management system may be part of or for an electrical system or installation, including but not limited to distribution cabinets, metering cabinets, electrical automats, and others.

It is noted that the above aspects, examples and features may be combined with each other irrespective of the aspect involved.

The above and other aspects of the present disclosure will become apparent from and elucidated with reference to the examples described hereinafter.

### BRIEF DESCRIPTION OF THE DRAWINGS

Exemplary embodiments will be further described with reference to Figures, wherein:
Figure 1 shows a perspective view on a portion of a cable management system with an exemplary cable management device;
Figure 2 shows a perspective view on a portion of the cable management system with an alternative exemplary cable management device;
Figure 3 shows a different perspective view on a part of the cable management device of Fig. 2;
Figure 4 shows a front view on the cable management system; and
Figure 5 shows a front view on a portion of the cable management system.

The Figures are schematic only and not true to scale. In principle, identical or like parts, elements and/or steps are provided with identical or like reference numerals in the Figures.

### DETAILED DESCRIPTION OF THE INVENTION

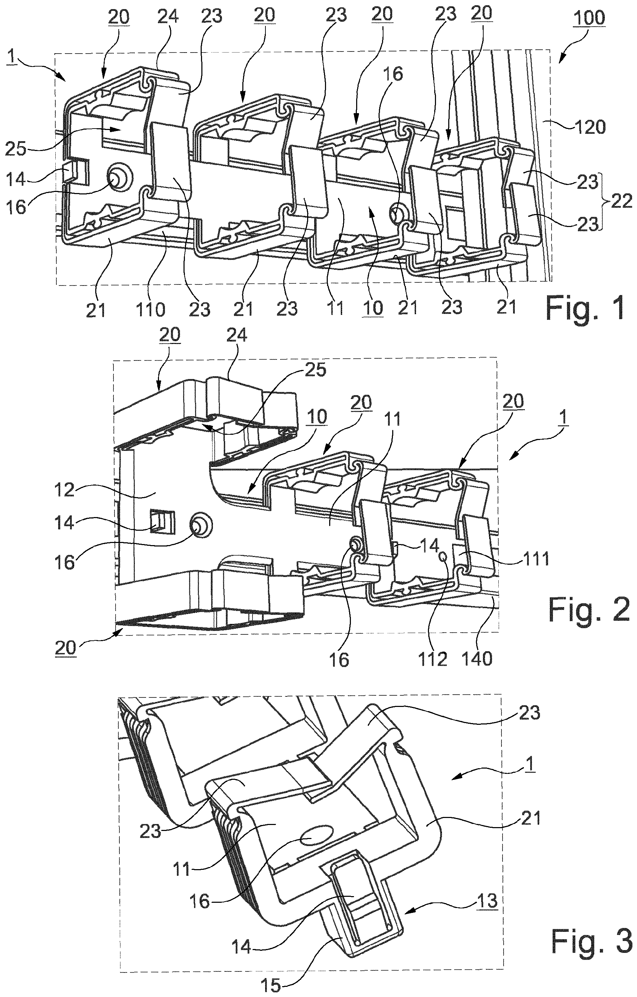

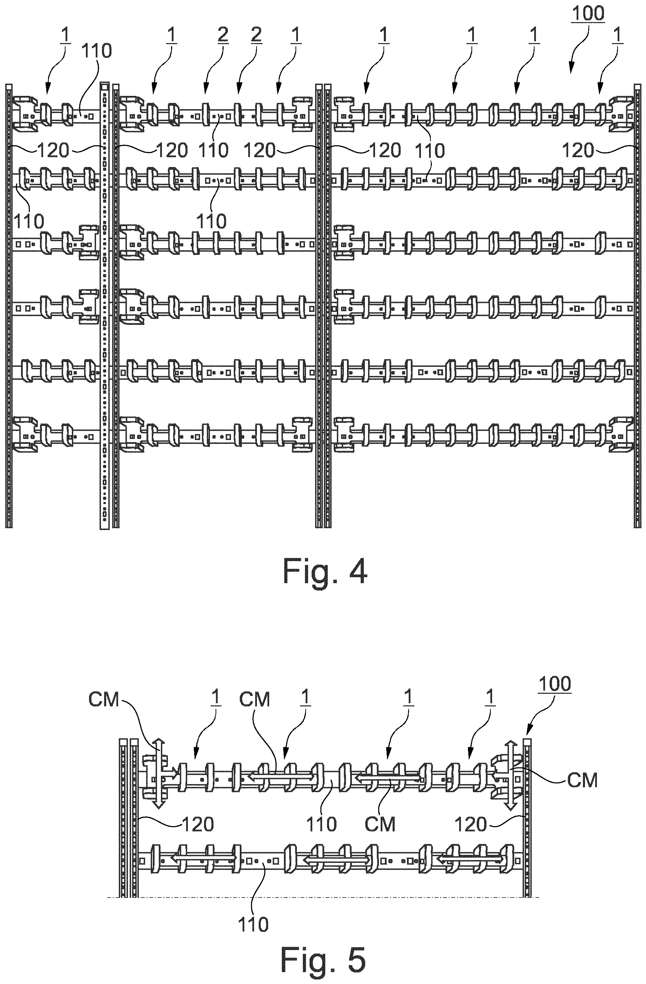

Fig. 1 shows a cable management device 1 for cable management. The cables are not included in any of the below Figures for the purpose of better illustrating the cable management device 1 and the cable management system 100 (see Fig. 4) in which it is being used.

The cable management device 1 of Fig. 1 is used in a cable management system 100, which in the partial view of the cable management system 100 of Fig. 1 (see Fig. 4 for full view) is seen with a post 120, in particular a vertical or vertically arranged post 120, and a thereto attached rail 110, in particular a horizontal or horizontally arranged rail 110. As may be seen in Fig. 4, the cable management system 100 may comprise several of such posts 120 and rails 110, which may be used in electrical systems or installations, including but not limited to distribution cabinets, metering cabinets, electrical automats, and others. For example, the rail 110 and/or the post 120 may be designed according to a standard, e.g., an industry norm from Deutsches Institut für Normung, DIN.

The cable management device 1 in the example of Fig. 1 comprises a connection structure 10. The connection structure 10 comprises or is in the form of a bar element 11. Arranged at the connection structure 10 are in this example four cable holders 20, which are spaced apart from one another, in particular in longitudinal direction of the connection structure 10 or bar element 11. Also, the cable holders 20 are exemplary arranged in parallel to one another. The number of cable holders 20 may be less, e.g., two or three, or more. Also, the arrangement of the cable holders 20 with respect to each other may be different as discussed with reference to Fig. 2 further below.

Each one of the cable holders 20 comprises a rigid portion 21 and a flexible portion 22. The rigid portion 21 is substantially rigidly designed relative or compared to the flexible portion 22, whereas the flexible portion 22 is flexible relative or compared to the rigid portion 21. Specifically, the flexible portion 22 may comprise two flexible arms 23. These two flexible arms 23 may be arranged at or form a front side or, in other words, be opposite of the connection structure 10 and/or the bar element 11, which may form or be a back side of the cable management device 1. Thereby, the cable or cables may be easily introduced into or inside of the cable holders 20, in particular from the front when facing the cable management device 1 connected to the rail 110.

Specifically, the flexible arms 23 may be flexible with respect to the rigid portion 21 due to their design. As seen in Fig. 1, specifically, the flexible arms 23 may be arranged at the rigid portion 21 in a flexible way or, in other words, such that these may be flexed or bent, in particular away and/or towards one another, thereby allowing to introduce one or more cables into a space 25 formed by an overall frame 24 or, in other words, frame structure of the cable holders 20. Specifically, the frame 24 may have a substantially rectangular, e.g., square, shape. The frame 24 may be formed by the flexible portion 22, the rigid portion 21 and/or the bar element 11 as seen in Fig. 1.

To increase rigidty of the rigid portion 21, a double-walled structure of the rigid portion 21 is exemplary shown in Fig. 1, which however is optional. The flexible portion 22 on the other hand has no double-walled or double-layered structure but rather a single layer of material with no space in between the two walls or layers as seen for the rigid portion 21. In general, the cable management device 1 may be designed monolothically, from one piece or, in other words, from the same material, e.g., a plastic material. This allows for a light-weight and easy to manufacture cable management device 1.

As seen in Fig. 1, each one of the frames 24 extends from the connection structure 10 or bar element 11 connected to the rail 110. Specifically, a first side of the frame 24 or rigid portion 21 extends with or is arranged at the connection structure 10 or bar element 11. From there, two parallel or opposide sides of the frame 24 or rigid portion 21 extend substantially perpendicular to a direction of extension of the bar element 11 or, in other words, towards the front of the cable management device 1. That is, the cable management device 1 may have a back or back side at the connection structure 10 or bar element 11, by means of which or at which it may be attached or, in other words, connected to the rail 110. Opposite thereof, the cable management device 1 may have a front or front side, at which the flexible portion 22 may be located for inserting therethrough and receiving the one or more cables.

Fig. 2 shows an alternative example of a cable management device 1 comprising exemplary four cable holders 20. It is noted that the dimensions of the cable holders 20 here may alternatively be smaller, e.g., such that the space 25 is smaller, compared to what is shown in Fig. 2, or larger. Also, there may be different sizes and/or numbers of cable holders 20, frames 24 and/or spaces 25 in a set of two or more cable management devices 1.

Specifically, the connection structure 10 of this example comprises two bar elements 11, 12 arranged in a substantially T-shaped form. Alternatively, any oblique orientation or arrangement of the two bar elements 11, 12 with respect to each other with an oblique angle between 0 and 90 degrees may be provided. In the substantially T-shaped example, a first cable holder 20 on the right of Fig. 1 is arranged at an end of a first bar element 11 of the two bar elements 11, 12. Two second cable holders 20 on the left of Fig. 2 are arranged substantially in parallel to each other and at opposite ends of a second bar element 12 of the two bar elements 11, 12. Thereby, cables inserted into or received by all of the cable holders 20 of the cable management device 1 of Fig. 2 may not only be guided horizontally, in case the rail 110 is a horizontal rail 110 or horizontally arranged, but also may be guided from horizontal to vertical and vice versa, specifically, both, up and down, e.g., when there are several rails 110 arranged in parallel to one another as exemplarily shown in Figs. 4 and 5.

The first bar element 11 may be a horizonal bar element 11 or horizontally arranged. In particular, the horizonal bar element 11 may be configured for attachment to the rail 110, in particular in a congruent manner. This means that the horizontal bar element 11 may comprise a width smaller or equal to the width of the rail 110. Specifically, the horizontal bar element 11 may be comprising connection elements 13, 16 as further discussed herein. The second bar element 12 may be a vertical bar element 12 or vertically arranged, in particular by virtue of the first bar element 11 being configured for attachment to the rail 110.

Fig. 3 shows a portion of the cable management device 1 of Fig. 2. Here, a connection element 13 of the cable management device 1 may be seen particularly well. This connection element 13 may be used to connect the connection structure 10 and thus the cable management device 1 to the rail 110 as seen in Figs. 1 and 2, by inserting the connection element 13 into a corresponding connection openining 111 of the rail 110 as seen in Fig. 2. In particular, the cable management device 1 may comprise two of these connection elements 13, arranged opposite of one another, in particular at or near opposite ends of the connection structure 10, in particular a bar element 11 thereof, in particular a horizontal bar element 11 thereof, as shown.

The connection element 13 is shown with a snap-fit arm 14 for establishing a snap-fit connection or, in other words, joint with the rail 110, in particular the connection opening 111 thereof. For this purpose, the snap-fit arm 14 may be elastic or flexible such that it flexibly or elastically bends when inserting it through the connection opening 111 and consequently snaps or interlocks with the connection structure 10, thereby securely holding it in place.

Moreover, to prevent rotation of the cable management device 1 at the rail 110, the connection element 13 comprises an at least partially rectangulary shaped projection 14 for insertion into the connection opening 111 of the rail 110, which is rectangulary shaped in this example. Alternatively, the projection 15 and the connection opening 111 may have any other shape, such as but not limited to circular, for example. As seen in Fig. 3, the projection 15 of this example has three sides forming the at least partially rectangular shape, wherein two sides are formed by opposing walls and in between these, there is arranged the snap-fit arm 14. The projection 15 may in particular have a substantially C- or U-shaped form as seen herein, in particular with the snap-fit arm 14 being located in between two opposing sides or walls of the projection 15.

Moreover, as seen in Figs. 1, 2 and 3, the connection structure 10, in particular the bar element 11, may comprise one, two or more further connection elements 16 in the form of through-holes. These may be used to additionally or alternatively attach the connection device 1 to the rail 110, specifically by using through-holes 112 on the rail 110 and establishing a screw connection between the rail 110 and the cable management device 1.

Figs. 4 and 5 show a cable management system 100 using several of the cable management devices 1 described herein on several horizontally arranged rails 110 attached to vertically arranged posts 120. In the portion of the cable management system 100 shown in Fig. 5, an indication in arrows is given for guiding the cable management CM or, in other words, for guiding the cables through the different types of cable management devices 1. Depending on their type and arrangement at the rails 110, the cable management devices 1 may be used to vertically and horizontally guide and thus manage the cables to be used inside the cable management system 100.

Besides the cable management devices 1, the cable management system 100 includes some conventional cable holders with clips 2, which have the disadvatanges compared to the cable management devices 1 as initially discussed.

While the invention has been illustrated and described in detail in the drawings and foregoing description, such illustration and description are to be considered illustrative or exemplary and not restrictive. The invention is not limited to the disclosed embodiments. Other variations to the disclosed embodiments can be understood and effected by those skilled in the art and practicing the claimed invention, from a study of the drawings, the disclosure, and the claims.

As used herein, the word "comprising" does not exclude other elements, and the indefinite article "a" or "an" does not exclude a plurality. The mere fact that certain measures are recited in mutually different dependent claims does not indicate that a combination of these measures cannot be used to advantage. Further, as used herein, the phrase "at least one" or similar, e.g., "one or more of", in reference to a list of one or more entities should be understood to mean at least one entity selected from any one or more of the entities in the list of entities, but not necessarily including at least one of each and every entity specifically listed within the list of entities and not excluding any combinations of entities in the list of entities. This definition also allows that such entities may optionally be present other than the entities specifically identified within the list of entities to which the phrase "at least one" or similar refers, whether related or unrelated to those entities specifically identified. Thus, as a non-limiting example, "at least one of A and B" (or, equivalently, "at least one of A or B" or, equivalently "at least one of A and/or B" or, equivalently "one or more of A and B", "one or more of A or B", or "one or more of A and/or B") may refer, in one example, to at least one, optionally including more than one, A, with no B present (and optionally including entities other than B); in another example, to at least one, optionally including more than one, B, with no A present (and optionally including entities other than A); in yet another example, to at least one, optionally including more than one, A, and at least one, optionally including more than one, B (and optionally including other entities). In other words, the phrases "at least one," "one or more," and "and/or" are open-ended expressions that are both conjunctive and disjunctive in operation. For example, each of the expressions "at least one of A, B, and C," "at least one of A, B, or C," "one or more of A, B, and C," "one or more of A, B, or C," and "A, B, and/or C" may mean A alone, B alone, C alone, A and B together, A and C together, B and C together, A, B, and C together, and optionally any of the above in combination with at least one other entity.

As used herein, the phrase "being indicative of" may for example mean "reflecting" and/or "comprising". Accordingly, an entity, element and/or step referred to herein as "being indicative of [...]" can be synonymously or interchangeably used herein with one, two or all of said entity, element and/or step "comprising [...]" and said entity, element and/or step "reflecting [...]". Further, as used herein, phrases such as "based on", "related" or "relating", "associated" and similar are not to be seen exclusively in terms of the entities, elements and/or steps to which they are referring, unless otherwise stated. Instead, these phrases are to be understood inclusively, unless otherwise stated, in that, for example, an entity, element or step referring by any of these phrases or similar, e.g., being "based on", an or another entity, element or step, does not exclude that the respective entity, element or step may be further or also "based on" any other entity, element or step than the one to which it refers.

The designation of elements, parts, sections or segments and similar as first, second, etc. as provided herein is merely intended to make the elements referenceable and distinguishable from one another. By no means does the designation of elements constitute a limitation of the scope of this disclosure. For example, when this disclosure describes a second element, a first or second step element do not need to be present yet alone be performed before the third step unless they are explicitly referred to as being required per se or before the third step.

Any reference signs in the claims should not be construed as limiting the scope.

## Claims

1. A cable management device (1) comprising a connection structure (10), the connection structure (10) comprising at least one connection element (13) for connection to a rail (110) of an electrical installation, and at least two cable holder (20) for holding one or more cables, the at least two cable holders (20) being arranged at a distance from one another on the connection structure (10), each one of the at least two cable holders (20) comprising a frame (24) to hold the one or more cables inside a space (25) enclosed by the frame (24), the frame (24) comprising at least a flexible portion (22) for receiving the one or more cables inside the space (25) and releasing them from the space (25).

2. The cable management device (1) of claim 1, wherein the flexible portion (22) comprises two flexible arms (23) configured for receiving and releasing the one or more cables through an opening formable between the two flexible arms (23) when flexing the flexible arms (23).

3. The cable management device (1) of any one of the previous claims, wherein the frame (24) comprises a rigid portion (21) for enclosing the one or more cables inside the space (25) enclosed by the frame (24), the rigid portion (21) being arranged at the flexible portion (22), and the rigid portion (21) being substantially rigid or less flexible than the flexible portion (22).

4. The cable management device (1) of any one of the previous claims, wherein the connection structure (10) comprises at least two connection elements (13).

5. The cable management device (1) of any one of the previous claims, wherein the at least one connection element (13) comprises a snap-fit arm (14) for establishing a snap-fit connection with the rail (110).

6. The cable management device (1) of claim 5, wherein the at least one connection element (13) comprises an at least partially rectangularly shaped projection (15) for insertion into a rectangular connection opening (111) inside the rail (110), the projection (15) comprising the snap-fit arm (14).

7. The cable management device (1) of any one of the previous claims, wherein the cable management device (1) further comprises at least one further connection element (16) configured as a through-hole for establishing a screwed connection with the rail (110).

8. The cable management device (1) of any one of the previous claims, wherein the connection structure (10) comprises at least one bar element (11, 12) at which the two or more cable holders (20) are arranged.

9. The cable management device (1) of any one of the previous claims, wherein one of the at least two cable holders (20) is arranged substantially in parallel to at least one other of the at least two cable holders (20), and/or wherein one of the at least two cable holders (20) is arranged substantially perpendicular to at least one other of the at least two cable holders (20).

10. The cable management device (1) of any one of the previous claims, wherein the connection structure (10) comprises two bar elements (11, 12) arranged oblique to one another.

11. The cable management device (1) of claim 10, wherein the two bar elements (11, 12) are arranged in a substantially T-shaped form, wherein one first cable holder (20) is arranged at an end of a first bar element (11) of the two bar elements (11, 12), and wherein two second cable holders (20) are arranged substantially in parallel to each other at opposite ends of a second bar element (12) of the two bar elements (11, 12).

12. The cable management device (1) of claim 11, wherein the second cable holders (20) are arranged substantially perpendicular to the first cable holder (20).

13. The cable management device (1) of any one of the previous claims, wherein the frame (24) is substantially rectangulary shaped.

14. The cable management device (1) of any one of the previous claims, wherein the cable management device (1) comprises at least three cable holders (20).

15. A cable management system (100) comprising one or more cable management devices (1) according to any one of the previous claims, vertical posts (120) and horizontal rails (110), the horizontal rails (110) being attached to the vertical posts (120) and the one or more cable management devices (1) being connected to one or more of the horizontal rails (110).
